(19) Europäisches Patentamt / European Patent Office / Office européen des brevets

(11) **EP 2 705 381 B1**

(12) **FASCICULE DE BREVET EUROPEEN**

(45) Date de publication et mention
de la délivrance du brevet:
**02.03.2016 Bulletin 2016/09**

(21) Numéro de dépôt: **12724686.6**

(22) Date de dépôt: **26.04.2012**

(51) Int Cl.:
***G01R 31/36*** *(2006.01)* ***B60L 11/18*** *(2006.01)*

(86) Numéro de dépôt international:
**PCT/FR2012/050923**

(87) Numéro de publication internationale:
**WO 2012/150405 (08.11.2012 Gazette 2012/45)**

(54) **PROCEDE DE TRAITEMENT D'UN SIGNAL QUANTIFIANT L'ETAT DE CHARGE D'UNE BATTERIE ELECTRIQUE D'UN VEHICULE AUTOMOBILE EN FONCTION DU TEMPS**

VERFAHREN ZUR VERARBEITUNG EINES SIGNALS ZUR RECHTZEITIGEN QUANTIFIZIERUNG DES LADUNGSZUSTANDS EINER ELEKTRISCHEN BATTERIE EINES KRAFTFAHRZEUGS

METHOD FOR PROCESSING A SIGNAL QUANTIFYING THE STATE OF CHARGE OF AN ELECTRIC BATTERY OF A MOTOR VEHICLE IN TIME

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **05.05.2011 FR 1101396**

(43) Date de publication de la demande:
**12.03.2014 Bulletin 2014/11**

(73) Titulaire: **Renault S.A.S.**
**92100 Boulogne-Billancourt (FR)**

(72) Inventeurs:
• **MARSILIA, Marco**
**F-92100 Boulogne-Billancourt (FR)**
• **CREGUT, Samuel**
**F-78470 Saint Remy Les Chevreuse (FR)**

(74) Mandataire: **Rougemont, Bernard**
**Renault s.a.s**
**TCR GRA 2 36 - Sce 00267**
**1, Avenue du Golf**
**78084 Guyancourt Cedex (FR)**

(56) Documents cités:
| | |
|---|---|
| EP-A1- 1 707 974 | EP-A1- 1 983 349 |
| EP-A2- 1 801 604 | JP-A- 2000 150 003 |
| US-A1- 2003 214 303 | US-A1- 2004 076 872 |

**Description**

DOMAINE TECHNIQUE AUQUEL SE RAPPORTE L'INVENTION

La présente invention concerne un procédé de traitement d'un signal initial quantifiant l'état de charge d'une batterie d'un véhicule automobile en fonction du temps pour obtenir un signal filtré en fonction du temps.

L'invention s'applique en particulier à tout véhicule à moteur électrique alimenté par une batterie.

ARRIERE-PLAN TECHNOLOGIQUE

Dans un véhicule électrique, la quantité d'énergie stockée dans la batterie de traction est déterminée en temps réel, pendant le roulage.

La quantité d'énergie stockée dans une batterie est couramment exprimée en pourcentage de sa capacité maximale de stockage.

On appellera « état de charge » de la batterie cette quantité d'énergie stockée exprimée en pourcentage de la capacité maximale de stockage.

L'état de charge d'une batterie complètement chargée vaut donc 100% et celui d'une batterie vide vaut 0%.

Cette information est communiquée au conducteur à chaque instant via un écran du tableau de bord du véhicule.

Elle permet en outre de déterminer d'autres paramètres de fonctionnement du véhicule tels qu'une estimation du nombre de kilomètres que le véhicule peut encore parcourir grâce à la quantité d'énergie stockée dans la batterie et les couples moteur et générateur maximum du véhicule.

Il est donc important de déterminer l'état de charge de la batterie le plus précisément possible. Or, une estimation précise de l'état de charge pendant le roulage est possible uniquement dans certaines conditions de fonctionnement de la batterie, par exemple lorsque le courant entrant ou sortant de la batterie est proche de zéro.

Le document EP1707974 décrit une méthode d'estimation de l'état de charge d'une batterie utilisant une première estimation obtenue en intégrant le courant de charge/décharge de la batterie, et un second taux de charge obtenu en fonction de la tension à vide mesurée aux bornes de la batterie. Dans cette méthode on régule la différence entre le second taux de charge et un taux de charge final calculé à partir de la première estimation de l'état de charge de la batterie et de cette différence.

Le document EP1983349 décrit un procédé de calcul d'un taux de charge d'une batterie dans lequel on calcule un état de charge prévisionnel en intégrant le courant de charge/décharge de la batterie et en fonction du taux de charge calculé à un instant t-1, on calcule un état de charge estimé en fonction de la tension à vide de la batterie , et on calcule le taux de charge à l'instant t en fonction notamment de l'état de charge prévisionnel, de l'état de charge estimé et du taux de charge calculé à l'instant t-1.

Le document US2004076872 décrit un procédé de détermination de l'état de charge d'une batterie dans un véhicule hybride, dans lequel le calcul de l'état de charge utilise la mesure de l'impédance de la batterie quand celle-ci est réalisable, ainsi qu'une intégration du courant entrant ou sortant de la batterie, une mesure de température de la batterie, et une mesure de la tension continue fournie par la batterie.

Le document US20030214303 décrit une méthode de détermination de l'état de charge d'une batterie au plomb. Cette méthode intègre trois méthodes indépendantes: la détermination d'un état de charge par intégration du courant entrant/sortant dans la batterie, la détermination d'un état de charge utilisant la tension à vide de la batterie, et la mesure de l'état de charge du véhicule lorsque celui-ci est arrêté.

Le document EP1801604 décrit une méthode d'estimation d'un état de charge d'une batterie, dans laquelle on calcule une première estimation de l'état de charge par intégration du courant entrant/sortant dans la batterie, on calcule ensuite la tension à vide de la batterie correspondant à un état de charge nul de celle-ci, et on empêche l'erreur entre d'une part l'estimation de l'état de charge utilisant l'intégration du courant batterie et d'autre part l'estimation de l'état de charge utilisant la tension à vide de la batterie à état de charge nul, de diverger.

Enfin le document JP2000150003 décrit une méthode d'estimation de l'état de charge d'une batterie dans laquelle on corrige une première estimation d'état de charge utilisant l'intégration du courant batterie, par une estimation d'état de charge utilisant deux mesures de tension à vide de la batterie.

Les algorithmes d'estimation connus de l'état de charge de la batterie effectuent alors régulièrement des « recalages », c'est-à-dire des corrections instantanées ou très rapides de l'estimation aux instants où ces conditions de fonctionnement se produisent.

A ces instants, l'état de charge estimé et affiché à l'écran du tableau de bord varie donc brusquement pour atteindre une estimation corrigée plus précise.

Ces variations rapides de l'état de charge présentent l'inconvénient d'être difficilement compréhensibles par l'utilisateur et peuvent lui donner l'impression de disposer d'une information peu fiable.

Les variations de l'état de charge de la batterie peuvent aussi être ressenties par l'utilisateur, par exemple dans le cas d'une limitation du couple moteur lié à cet état de charge.

L'utilisateur s'attend également à ce que les variations de l'état de charge suivent l'évolution des flux de puissance entrant et sortant de la batterie, c'est-à-dire qu'il s'attend à ce que l'état de charge augmente lorsqu'on récupère de l'énergie, par exemple lors d'un lâcher de la pédale d'accélérateur ou d'un freinage, et à ce que l'état de charge diminue lorsqu'on consomme de l'énergie, par exemple pendant une accélération.

Lors des recalages, l'évolution de l'état de charge de la batterie affichée sur l'écran du tableau de bord ne suit pas forcément la variation « intuitive » attendue par l'utilisateur, et n'est donc pas en accord avec la perception de cet état de charge par l'utilisateur.

OBJET DE L'INVENTION

Afin de remédier à l'inconvénient précité de l'état de la technique, la présente invention propose un procédé de traitement du signal d'estimation de l'état de charge de la batterie permettant d'obtenir un signal filtré représentatif de l'état de charge de la batterie avec une précision satisfaisante et dont l'évolution reste intuitive et compréhensible par l'utilisateur.

A cet effet, on propose selon l'invention un procédé tel que défini en introduction selon lequel on réalise, à chaque instant t, les étapes suivantes :

a) on détermine une différence DIFF(t) entre la valeur SOC_Brut(t) du signal d'estimation initial à l'instant t et la valeur du signal filtré SOC_Filtre(t-1) déterminée à l'instant précédent t-1,

b) on détermine une variation théorique VARTH(t) de l'état de charge de la batterie à l'instant t en fonction de la puissance électrique fournie ou récupérée par la batterie à l'instant t, et

c) on détermine la valeur du signal filtré SOC_Filtre(t) à l'instant t en fonction de la différence DIFF(t) déterminée à l'étape a) et de la variation théorique VARTH(t) déterminée à l'étape b), de telle sorte que le signal filtré (SOC Filtre(t)) converge vers le signal initial (SOC Brut(t)).

D'autres caractéristiques non limitatives et avantageuses du procédé conforme à l'invention sont les suivantes :

- à l'étape c) :

° d) on détermine au moins un coefficient de variation P1(t), P2(t) du signal filtré SOC_Filtre(t) à l'instant t, en fonction de la différence DIFF(t) déterminée à l'étape a) et de la variation théorique Variat_TH(t) déterminée à l'étape b), et

° e) on détermine une valeur du signal filtré SOC_Filtre(t) à l'instant t en fonction de ce coefficient de variation P1(t), P2(t) et de la durée Dt séparant l'instant t de l'instant précédent t-1 ;

- à l'étape e), on ajoute à la valeur SOC_Filtre(t-1) du signal filtré à l'instant précédent t-1 le produit de ce coefficient de variation P1(t), P2(t) et de la durée Dt séparant l'instant t de l'instant précédent t-1 ;

Les coefficients de variation P1 (t), P2(t) déterminent à chaque instant t la variation du signal filtré.

- le procédé comporte les étapes suivantes :

d1) on détermine, à l'étape d), un premier coefficient de variation P1(t) du signal filtré SOC_Filtre(t) à l'instant t, correspondant au cas où la valeur du signal filtré SOC_Filtre(t) à l'instant t déterminée par ledit procédé est supérieure à la valeur du signal initial SOC_Brut(t) à l'instant t,

e1) on détermine, à l'étape e), une première valeur V1 possible du signal filtré SOC_Filtre(t) à l'instant t, en fonction du premier coefficient de variation P1 (t) et de la durée Dt séparant l'instant t de l'instant précédent t-1,

f1) on compare la première valeur V1 déterminée à l'étape e1) avec la valeur du signal initial SOC_Brut(t) à l'instant t, et

g1) on détermine la valeur du signal filtré SOC_Filtre(t) en fonction du résultat de la comparaison réalisée à l'étape f1) ;

- la comparaison réalisée à l'étape f1) ayant montré que la première valeur V1 est supérieure à la valeur du signal initial SOC_Brut(t), la valeur du signal filtré SOC_Filtre(t) à l'instant t est déterminée comme étant égale à la première valeur V1 possible ;
- le procédé comporte les étapes suivantes :

d2) on détermine, à l'étape d), un deuxième coefficient de variation P2(t) du signal filtré SOC_Filtre(t) à l'instant t correspondant au cas où la valeur du signal filtré SOC_Filtre(t) à l'instant t déterminée par ledit procédé est inférieure à la valeur du signal initial SOC_Brut(t) à l'instant t,

e2) on détermine, à l'étape e), une deuxième valeur V2 possible du signal filtré SOC_Filtre(t) à l'instant t, en ajoutant à la valeur SOC_Filtre(t-1) du signal filtré à l'instant précédent t-1 le produit du deuxième coefficient de variation P2(t) et de la durée Dt séparant l'instant t de l'instant précédent t-1,

f2) on compare la deuxième valeur V2 déterminée à l'étape e2) avec la valeur du signal initial SOC_Brut(t) à l'instant t, et

g2) on détermine la valeur du signal filtré SOC_Filtre(t) en fonction du résultat de la comparaison réalisée à l'étape f2) ;

- la comparaison réalisée à l'étape f2) ayant montré que la deuxième valeur V2 est inférieure à la valeur du signal initial SOC_Brut(t), la valeur du signal filtré SOC_Filtre(t) à l'instant t est déterminée comme étant égale à la deuxième valeur V2 possible ;
- la comparaison réalisée à l'étape f1) ayant montré que la première valeur V1 est inférieure à la valeur du signal initial SOC_Brut(t), et la comparaison réalisée à l'étape f2) ayant montré que la deuxième valeur V2 est supérieure à la valeur du signal initial SOC_Brut(t), la valeur du signal filtré SOC_Filtre(t) à l'instant t est déterminée comme étant égale à la valeur du signal initial SOC_Brut(t) à l'instant t ;
- le premier coefficient de variation P1(t) du signal filtré SOC_Filtre(t) à l'instant t est déterminé en fonction de la première somme S1 (t) de la variation théorique Variat_TH(t) de l'état de charge de la batterie à l'instant t, du produit d'un premier facteur K11 et de la différence DIFF(t) déterminée à l'étape a), et d'un deuxième facteur K12.
- le premier facteur K11 est positif ou nul et le deuxième facteur K12 est négatif ou nul ;
- le premier facteur K11, est une constante ou une fonction d'autres signaux et le deuxième facteur K12 est une constante ;
- le premier coefficient de variation P1 (t) est égale au minimum de ladite première somme S1(t) et d'une valeur maximale prédéterminée K13 ;
- le deuxième coefficient de variation P2(t) du signal filtré SOC_Filtre(t) à l'instant t est déterminé en fonction de la deuxième somme S2(t) de la variation théorique Variat_TH(t) de l'état de charge de la batterie à l'instant t, du produit d'un troisième facteur K21 et de la différence DIFF(t) déterminée à l'étape a), et d'un quatrième facteur K22 ;
- les troisième et quatrième facteurs K21, K22 sont positifs ou nuls ;
- le troisième facteur K21 est une constante ou une fonction d'autres signaux et le quatrième facteur K22 est une constante ;
- le deuxième coefficient de variation P2(t) est égale au maximum de ladite deuxième somme S2(t) et d'une valeur minimale prédéterminée K23 ;
- la variation théorique Variat_TH(t) de l'état de charge de la batterie à l'instant t est égale à la puissance électrique fournie ou récupérée par la batterie à l'instant t multipliée par un facteur de conversion Kconv ;
- au premier instant t0 de mise en oeuvre du procédé, la valeur du signal filtré SOC_Filtre(t0) est égale à la valeur du signal initial SOC_Brut(t0) à ce premier instant.

L'invention propose également un véhicule automobile comportant une batterie électrique et une unité de commande informatique et électronique programmée pour traiter un signal initial SOC_Brut(t) quantifiant l'état de charge d'une batterie électrique selon le procédé décrit précédemment.

DESCRIPTION DETAILLEE D'UN EXEMPLE DE REALISATION

La description qui va suivre en regard des dessins annexés, donnés à titre d'exemples non limitatifs, fera bien comprendre en quoi consiste l'invention et comment elle peut être réalisée.

Sur les dessins annexés :

- la figure 1 est une vue globale schématique des différentes étapes du procédé de traitement du signal initial quantifiant l'état de charge d'une batterie électrique selon l'invention,
- les figures 2, 3, 4 et 5 sont respectivement des représentations schématiques d'un exemple de réalisation de chacun des blocs 1, 2, 3 et 4 de la figure 1,
- la figure 6 est une représentation schématique d'un exemple d'étapes de détermination de l'un des paramètres utilisés dans le bloc 3 de la figure 1, et
- la figure 7 comporte dans sa partie haute une représentation graphique de l'évolution du signal initial SOC_Brut(t) en fonction du temps (courbe en marches d'escalier), du signal filtré SOC_Filtre (t) en fonction du temps obtenu par le procédé de la figure 1 (courbe lisse en trait plein) et l'évolution du signal obtenu en intégrant la puissance de la batterie au cours du temps (trait pointillé) ; dans sa partie basse, la figure 7 comporte une représentation graphique de l'évolution concomitante du couple du moteur électrique alimenté par la batterie du véhicule correspondant.

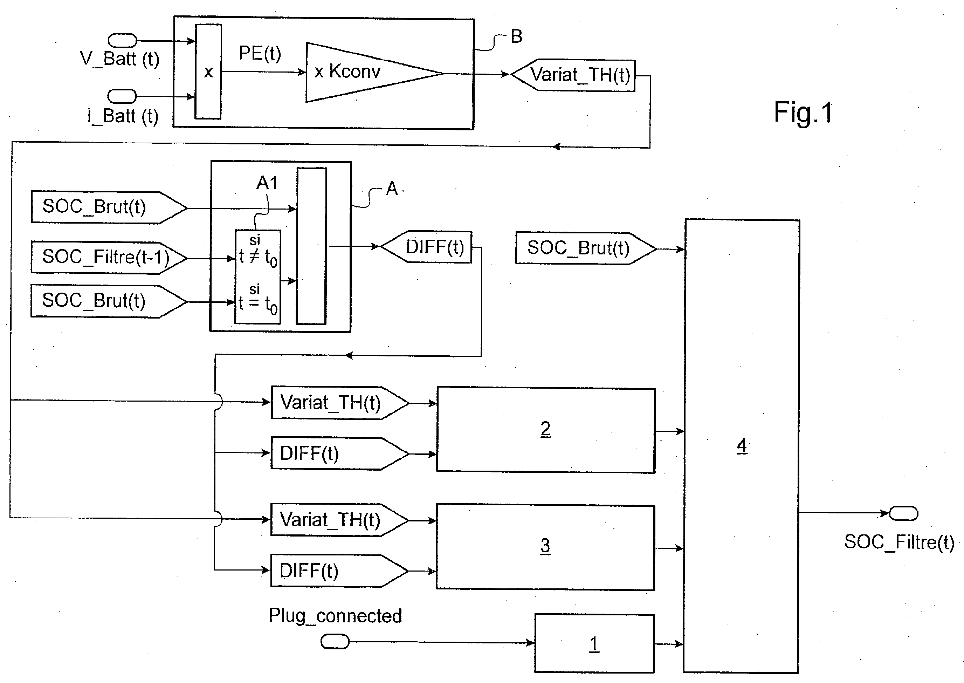

Sur la figure 1, on a représenté schématiquement les différentes étapes du procédé selon l'invention.

Ce procédé est par exemple mis en oeuvre par une unité de commande informatique et électronique du véhicule qui reçoit les signaux de différents capteurs du moteur du véhicule. Cette unité de commande est programmée pour mettre en oeuvre différents procédés, dont le procédé selon l'invention.

Ce procédé concerne le traitement d'un signal initial SOC_Brut(t) quantifiant l'état de charge d'une batterie électrique d'un véhicule automobile en fonction du temps pour obtenir un signal filtré SOC_Filtre(t) en fonction du temps dont les variations restent compréhensibles de manière intuitive pour l'utilisateur.

Le signal initial SOC_Brut(t) est obtenu de manière connue en soi, par exemple grâce à un algorithme d'estimation de l'état de charge de la batterie.

Cet algorithme permet une estimation de l'état de charge de la batterie à partir par exemple de la valeur du courant de décharge de la batterie mesuré à l'instant t ou de la tension aux bornes de la batterie mesurée à l'instant t.

Cet algorithme ne fait pas l'objet de la présente invention et ne sera pas décrit en détail ici.

Selon le procédé conforme à l'invention, on réalise, à chaque instant t, les étapes suivantes :

a) on détermine une différence DIFF(t) entre la valeur SOC_Brut(t) dudit signal initial à l'instant t et la valeur du signal filtré SOC_Filtre(t-1) déterminée à l'instant précédent t-1,

b) on détermine une variation théorique Variat_TH(t) de l'état de charge de la batterie à l'instant t en fonction de la puissance électrique fournie ou récupérée par la batterie à l'instant t,

c) on détermine en fonction de la différence DIFF(t) déterminée à l'étape a) et de la variation théorique Variac_TH(t) déterminée à l'étape b) la valeur du signal filtré SOC_Filtre(t) à l'instant t.

Les instants t correspondent aux instants successifs de mise en oeuvre du procédé. En pratique, le procédé est réitéré à intervalles de temps régulier espacés d'une durée Dt.

On note t-1 l'instant précédant l'instant t et qui correspond donc au temps t-Dt.

Etape a)

L'étape a) est représentée par le bloc A de la figure 1.

La différence DIFF(t) entre la valeur SOC_Brut(t) du signal initial à l'instant t et la valeur SOC_Filtre(t-1) du signal filtré à l'instant précédent t-1 est calculée selon la formule : DIFF(t) = SOC_Brut(t) - SOC_Filtre(t-1), pour tous les instants t différents du premier instant de mise en oeuvre du procédé noté t0.

A t0, comme représenté sur le bloc A1 de la figure1,

$$DIFF(t0) = SOC\_Brut(t0) - SOC\_Brut(t0) = 0.$$

Etape b)

L'étape b) est représentée schématiquement par le bloc B de la figure 1.

Dans cette étape, la variation théorique Variat_TH(t) de l'état de charge de la batterie à l'instant t est déterminée en fonction de la puissance électrique PE(t) fournie ou récupérée par la batterie à l'instant t. La puissance électrique PE(t) fournie ou récupérée par la batterie est déterminée en fonction de la tension V_Batt (t) au borne de la batterie à l'instant t et de l'intensité du courant électrique I_Batt(t) entrant dans la batterie à cet instant.

Plus précisément, la puissance électrique PE(t) est égale au produit de la tension V_Batt(t) et de l'intensité I_Batt(t).

Selon le procédé, la variation théorique Variat_TH(t) est déterminée en multipliant la puissance électrique PE(t) par un facteur de conversion Kconv entre la puissance électrique exprimée en Watt et la variation de l'état de charge de la batterie exprimée en pourcentage par seconde, noté %/s.

Ce facteur de conversion Kconv peut être constant ou dépendre du temps. Quoi qu'il en soit, il dépend notamment des caractéristiques physiques de la batterie, par exemple de sa durée d'utilisation et de sa température.

Il peut être déterminé par une étape préalable de calibrage ou être déterminé en temps réel, en fonction par exemple de la température de la batterie mesurée par un capteur ou estimée.

Etape c)

A l'étape c), l'unité de commande détermine en fonction de la différence DIFF(t) déterminée à l'étape a) et de la variation théorique Variat_TH(t) déterminée à l'étape b) la valeur du signal filtré SOC_Filtre(t) à l'instant t.

Plus précisément, à l'étape c), l'unité de commande est programmée pour :

  d) déterminer au moins un coefficient de variation P1(t), P2(t) du signal filtré SOC_Filtre(t) à l'instant t, et
  e) déterminer la valeur du signal filtré SOC_Filtre(t) à l'instant t en ajoutant à la valeur SOC_Filtre(t-1) du signal filtré à l'instant précédent t-1 le produit de ce coefficient de variation P1 (t), P2(t) et de la durée Dt séparant l'instant t de l'instant précédent t-1.

De préférence, l'unité de commande est programmée pour déterminer deux coefficients de variation possibles, destinés chacun à être appliqué au signal filtré SOC_Filtre(t-1) à l'instant précédent t-1 pour calculer le signal filtré SOC_Filtre(t) selon que la valeur du signal filtré SOC_Filtre(t) obtenue à l'instant t par le procédé est supérieure ou inférieure à la valeur du signal initial SOC_Brut(t) à l'instant t.

Ces coefficients de variations P1 (t), P2(t) sont déterminés de manière à assurer une évolution intuitive du signal filtré SOC_Filtre pour l'utilisateur, tout en assurant que ce signal filtré reste proche de la valeur du signal initial SOC_Brut qui présente une grande précision.

Ainsi, à l'étape d), dans une sous-étape d1), l'unité de commande détermine un premier coefficient de variation P1 (t) du signal filtré SOC_Filtre(t) à l'instant t correspondant au cas où la valeur du signal filtré SOC_Filtre(t) déterminée à l'instant t par le procédé est supérieure à la valeur du signal initial SOC_Brut(t) à l'instant t.

Ce premier coefficient de variation P1(t) est donc destiné à être appliqué au signal filtré SOC_Filtre à condition qu'une première valeur V1 possible du signal filtré SOC_Filtre(t) déterminée à l'instant t grâce à ce premier coefficient de variation P1(t) soit supérieure à la valeur du signal initial SOC_Brut(t) à l'instant t considéré.

Comme cela sera exposé plus en détail ci-après, il est donc prévu ultérieurement une étape de comparaison f1) de cette première valeur V1 déterminée à l'instant t grâce à ce premier coefficient de variation P1 (t) avec la valeur du signal initial SOC_Brut(t) à l'instant t considéré.

Dans une sous-étape d2) de l'étape d), l'unité de commande détermine un deuxième coefficient de variation P2(t) du signal filtré SOC_Filtre(t) à l'instant t correspondant au cas où la valeur du signal filtré SOC_Filtre(t) déterminée à l'instant t par le procédé est inférieure à la valeur du signal initial SOC_Brut(t) à l'instant t.

Ce deuxième coefficient de variation P2(t) est donc destiné à être appliqué au signal filtré SOC_Filtre à condition qu'une deuxième valeur V2 possible du signal filtré SOC_Filtre(t) déterminée à l'instant t grâce à ce deuxième coefficient de variation P2(t) soit inférieure à la valeur du signal initial SOC_Brut(t) à l'instant t considéré.

Comme cela sera exposé plus en détail ci-après, il est donc prévu ultérieurement une étape de comparaison f2) de cette deuxième valeur V2 déterminée à l'instant t grâce à ce deuxième coefficient de variation P2(t) avec la valeur du signal initial SOC_Brut(t) à l'instant t considéré.

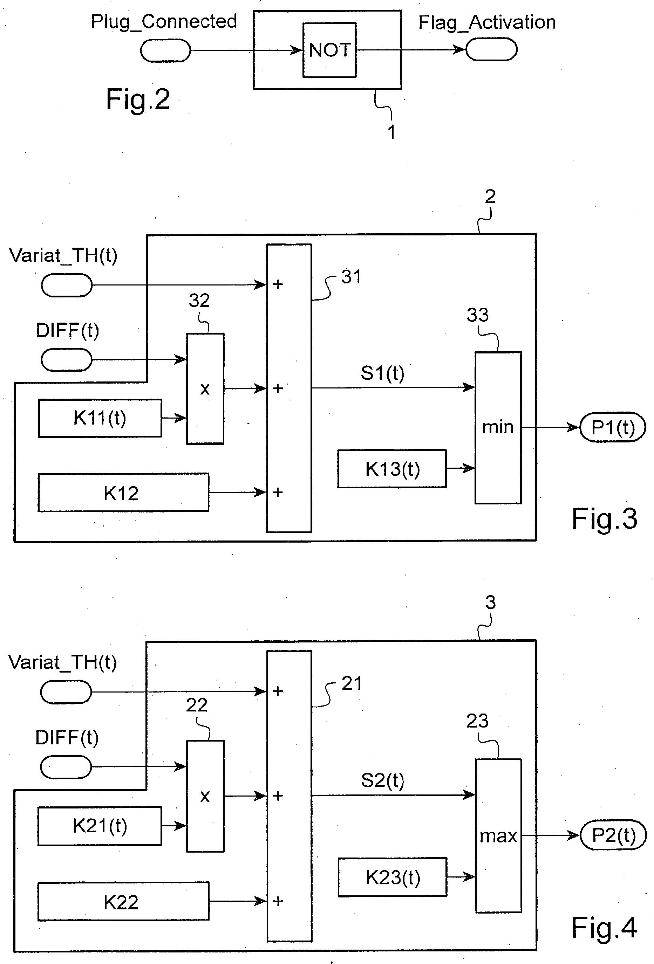

Les étapes d1) et d2) sont réalisées par les blocs 2 et 3 représentés respectivement sur les figures 3 et 4.

Les deux entrées du bloc 2 de la figure 3 sont, d'une part, la variation théorique Variat_TH(t) de l'état de charge de la batterie déterminé à l'étape b) et, d'autre part, la différence DIFF(t) déterminée à l'étape a).

A l'étape d1), l'unité de commande détermine le premier coefficient de variation P1(t) du signal filtré SOC_Filtre(t) à l'instant t en fonction de la première somme S1 (t) (bloc 31 de la figure 3) :

  -  de la variation théorique Variat_TH(t) de l'état de charge de la batterie à l'instant t,
  -  du produit (bloc 32 de la figure 3) d'un premier facteur K11 et de la différence DIFF(t) déterminée à l'étape a), et
  -  d'un troisième facteur K12,
    soit $S1(t) = Variat\_TH(t) + K11 * DIFF(t) + K12$.

Le premier coefficient de variation P1(t) dépend donc à la fois de la variation théorique de l'état de charge de la batterie qui représente la variation la plus intuitive pour l'utilisateur car directement proportionnelle à la puissance fournie ou récupérée par la batterie, et du produit du premier facteur K11 et de la différence DIFF(t) entre la valeur SOC_Brut(t) dudit signal initial à l'instant t et la valeur SOC_Filtre(t-1) du signal filtré à l'instant précédent t-1.

Le premier facteur K11 est de préférence positif ou nul.

Le produit K11*DIFF(t) constitue un terme qui tend à faire converger le signal filtré vers le signal initial, c'est-à-dire à faire diminuer la valeur absolue de la différence entre la valeur SOC_Brut(t) du signal initial à l'instant suivant t et la valeur du signal filtré SOC_Filtre(t) à cet instant t par rapport à la valeur absolue de la différence entre la valeur SOC_Brut(t-1) du signal initial à l'instant précédent t-1 et la valeur SOC_Filtre(t-1) du signal filtré à l'instant précédent t-1. Le premier facteur K11 est ainsi un facteur de convergence quantifiant la vitesse de convergence du signal filtré vers le signal initial.

Le signal filtré converge d'autant plus vite vers le signal initial, c'est-à-dire se rapproche d'autant plus vite du signal initial que le premier facteur K11 est grand et que la différence DIFF(t) est grande.

En outre, le premier facteur K11 peut être une constante ou une fonction du temps. Il peut dans ce dernier cas être déterminé, par exemple, en tenant compte de la valeur du signal initial SOC_Brut(t) à l'instant t et/ou de la valeur SOC_Filtre(t-1) du signal filtré à l'instant t-1.

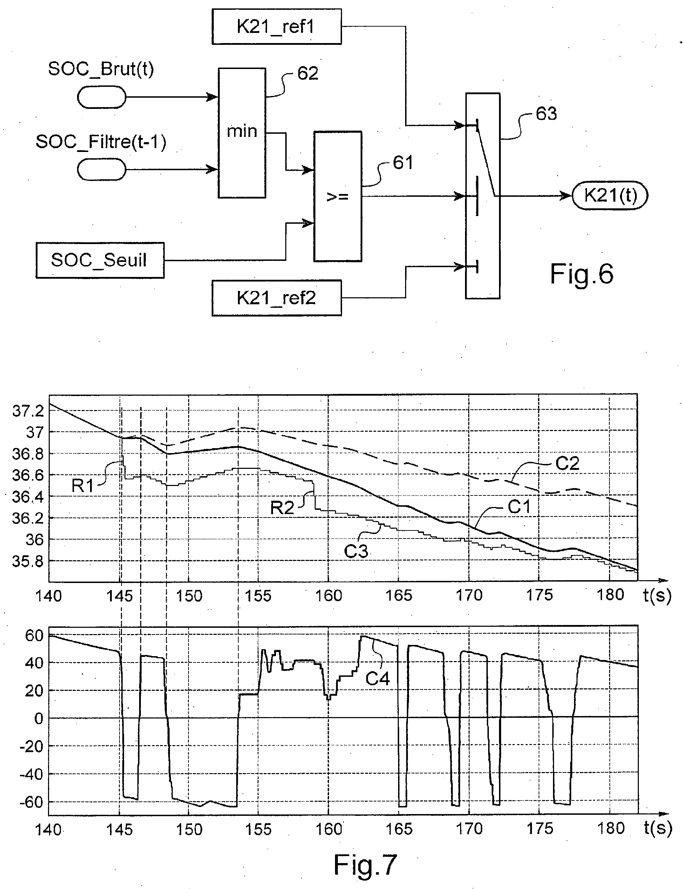

Ce premier facteur K11 peut par exemple être déterminé d'une manière similaire à celle décrite ultérieurement pour le troisième facteur K21 en référence à la figure 6.

Le deuxième facteur K12 est de préférence constant et négatif ou nul. Ce deuxième facteur K12 accélère la convergence du signal filtré vers le signal initial lorsqu'il est non nul.

De préférence, le premier coefficient de variation P1(t) présente une valeur maximale prédéterminée K13. Ce paramètre permet d'imposer une valeur maximale du signal filtré quand celui-ci est supérieur au signal initial. Ainsi le signal filtré ne peut par exemple diverger.

Le premier coefficient de variation P1(t) est alors égal au minimum (bloc 33 de la figure 3) de ladite première somme S1(t) et de ladite valeur maximale prédéterminée K13.

Le paramètre K13 représente alors la pente de croissance maximale du signal filtré SOC_Filtre(t) à l'instant t lorsque la valeur du signal filtré SOC_Filtre(t) à l'instant t est supérieure à la valeur SOC_Brut(t) du signal initial à l'instant t.

La valeur maximale prédéterminée K13 peut être constante ou dépendre du temps. Elle est dans ce dernier cas par exemple déterminée en fonction du signal initial et/ou du signal filtré à l'instant t et aux instants précédents.

Les deux entrées du bloc 3 de la figure 4 sont, d'une part, la variation théorique Variat_TH(t) de l'état de charge de la batterie déterminée à l'étape b) et, d'autre part, la différence DIFF(t) déterminée à l'étape a).

A l'étape d2), l'unité de commande détermine le deuxième coefficient de variation P2(t) du signal filtré SOC_Filtre(t) à l'instant t en fonction de la deuxième somme S2(t) (bloc 21 de la figure 4) :

- de la variation théorique Variat_TH(t) de l'état de charge de la batterie à l'instant t,
- du produit (bloc 22 de la figure 4) d'un troisième facteur K21 et de la différence DIFF(t) déterminée à l'étape a), et
- d'un quatrième facteur K22, soit :

$$S2(t) = Variat\_TH(t) + K21 * DIFF(t) + K22.$$

Ce deuxième coefficient de variation P2(t) dépend donc de la variation théorique Variat_TH(t) de l'état de charge de la batterie qui représente la variation la plus intuitive pour l'utilisateur car directement proportionnelle à la puissance fournie ou récupérée par la batterie.

Le deuxième coefficient de variation P2(t) dépend également du produit du troisième facteur K21 et de la différence DIFF(t) entre la valeur SOC_Brut(t) dudit signal initial à l'instant t à la valeur SOC_Filtre(t-1) du signal filtré à l'instant précédent t-1.

Le troisième facteur K21 est de préférence positif ou nul.

Le produit K21*DIFF(t) est un terme qui tend alors à faire converger le signal filtré vers le signal initial, c'est-à-dire à faire diminuer la valeur absolue de la différence entre la valeur SOC_Brut(t) du signal initial à l'instant suivant t et la valeur du signal filtré SOC_Filtre(t) à cet instant t par rapport à la valeur absolue de la différence entre la valeur SOC_Brut(t-1) du signal initial à l'instant précédent t-1 et la valeur SOC_Filtre(t-1) du signal filtré à l'instant précédent t-1.

Le troisième facteur K21 est un facteur de convergence quantifiant la vitesse de convergence du signal filtré vers le signal initial.

Le signal filtré converge d'autant plus vite vers le signal initial, c'est-à-dire se rapproche d'autant plus vite du signal initial que le troisième facteur K21 est grand et que la différence DIFF(t) est grande.

Le quatrième facteur K22 est de préférence constant, positif ou nul. Ce quatrième facteur K22 accélère la convergence du signal filtré vers le signal initial lorsqu'il est non nul.

Le troisième facteur K21 peut être une constante ou une fonction du temps.

Lorsqu'il dépend du temps, le troisième facteur K21(t) peut par exemple être déterminé selon les étapes représentées sur la figure 6, en fonction de la valeur du signal initial SOC_Brut(t) à l'instant t et de la valeur SOC_Fiitre(t-1) du signal filtré à l'instant précédent t-1.

Selon ces étapes, l'unité de commande compare (bloc 61 de la figure 6) une valeur seuil de l'état de charge SOC_Seuil prédéterminée avec le minimum (bloc 62 de la figure 6) de la valeur du signal initial SOC_Brut(t) à l'instant t et de la valeur SOC_Filtre(t-1) du signal filtré à l'instant précédent t-1.

Si le minimum de la valeur du signal initial SOC_Brut(t) à l'instant t et de la valeur SOC_Filtre(t-1) du signal filtré à l'instant précédent t-1 est supérieur ou égal à la valeur seuil SOC_Seuil, K21(t) est égale à une première valeur de référence K21_ref1 prédéterminée et sinon, K21(t) est égale à une deuxième valeur de référence K21_ref2 prédéterminée (bloc 63 de la figure 6).

Les valeurs seuil SOC_Seuil et de référence K21_ref1 et K21_ref2 sont constantes, positives ou nulles et prédéterminés lors d'une étape préalable de calibrage.

D'autres méthodes de détermination du facteur K21(t) peuvent être envisagées.

De préférence, le deuxième coefficient de variation P2(t) présente une valeur minimale prédéterminée K23. Ceci permet d'éviter que le signal filtré ne diverge.

Le deuxième coefficient de variation P2(t) est alors égal au maximum (bloc 23 de la figure 4) de ladite deuxième somme S2(t) et de ladite valeur minimale prédéterminée K23.

Le paramètre K23 représente alors la pente de décroissance maximale du signal filtré SOC_Filtre(t) à l'instant t lorsque la valeur SOC_Filtre(t) du signal filtré à l'instant t est inférieure à la valeur SOC_Brut(t) du signal initial à l'instant t.

La valeur minimale prédéterminée K23 peut être constante ou dépendre du temps. Elle est dans ce dernier cas par exemple déterminée en fonction du signal initial et/ou du signal filtré quantifiant l'état de charge de la batterie à l'instant t et aux instants précédents.

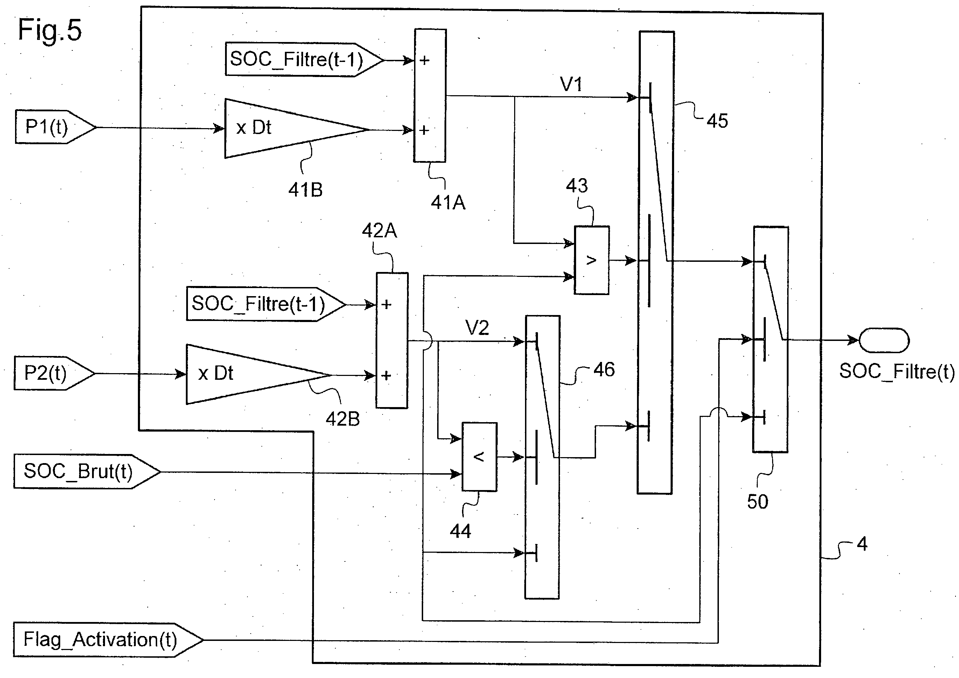

Ensuite, à l'étape e), dont la mise en oeuvre est représentée schématiquement sur la figure 5, l'unité de commande détermine, dans une étape e1), la première valeur V1 possible du signal filtré SOC_Filtre(t) à l'instant t en ajoutant (bloc 41 A de la figure 5) à la valeur SOC_Filtre(t-1) du signal filtré à l'instant précédent t-1 le produit (bloc 41 B de la figure 5) du premier coefficient de variation P1 (t) et de la durée Dt séparant l'instant t de l'instant précédent t-1.

L'unité de commande détermine également, dans une étape e2), la deuxième valeur V2 possible du signal filtré SOC_Filtre(t) à l'instant t en ajoutant (bloc 42A de la figure 5) à la valeur SOC_Filtre(t-1) du signal filtré à l'instant précédent t-1 le produit (bloc 42B de la figure 5) du deuxième coefficient de variation P2(t) et de la durée Dt séparant l'instant t de l'instant précédent t-1.

Ensuite, l'unité de commande compare, dans l'étape de comparaison f1), la première valeur V1, déterminée à l'étape e1), avec la valeur du signal initial SOC_Brut(t) à l'instant t (bloc 43 de la figure 5).

Si cette première valeur V1 est supérieure à la valeur du signal initial SOC_Brut(t), la valeur du signal filtré SOC_Fiitre(t) à l'instant t est déterminée, dans une étape g1), comme étant égale à la première valeur V1 possible (bloc 45 de la figure 5), soit SOC_Filtre(t) = V1.

Si cette première valeur V1 est inférieure ou égale à la valeur du signal initial SOC_Brut(t), l'unité de commande compare, dans l'étape de comparaison f2), la deuxième valeur V2 déterminée à l'étape e2) avec la valeur du signal initial SOC_Brut(t) à l'instant t (bloc 44 de la figure 5).

Si cette deuxième valeur V2 est inférieure à la valeur du signal initial SOC_Brut(t), la valeur du signal filtré SOC_Filtre(t) à l'instant t est déterminée à l'étape g2) comme étant égale à la deuxième valeur V2 possible (bloc 46 de la figure 5).

Si la première valeur V1 est inférieure ou égale à la valeur du signal initial SOC_Brut(t) et que la deuxième valeur V2 est supérieure ou égale à la valeur du signal initial SOC_Brut(t), la valeur du signal filtré SOC_Filtre(t) à l'instant t est déterminée comme étant égale à la valeur du signal initial SOC_Brut(t) à l'instant t (bloc 46 de la figure 5).

Sur le schéma de la figure 5, les blocs 45 et 46 sont des blocs du type « interrupteur » conditionnels: si la condition indiquée en entrée au centre est remplie, la sortie du bloc est connectée à l'entrée située le plus haut et sinon, la sortie est connectée à l'entrée située le plus bas dans le bloc.

Le bloc 63 de la figure 6 présente un fonctionnement similaire.

On peut prévoir en outre que le procédé de traitement du signal initial selon l'invention ne soit mis en oeuvre qu'à des moments donnés, déterminés par exemple en fonction des paramètres de fonctionnement du véhicule.

Par exemple, la mise en oeuvre du procédé est désactivée lorsque la batterie est connectée à une alimentation électrique externe pour sa recharge et activée lorsqu'elle est déconnectée de cette alimentation électrique externe, notamment en roulage.

A cet effet, on prévoit une étape de vérification de l'activation de la mise en oeuvre du procédé, représenté sur la figure 2 et sur le bloc 1 de la figure 1.

Lorsque la batterie est connectée à une alimentation externe, un signal noté « Plug_Connected » indiquant cette connexion est envoyé à l'unité de commande.

Selon l'exemple de réalisation représenté sur la figure 2, un signal noté « Flag-Activation » indiquant l'activation de la mise en oeuvre du procédé est généré par la négation du signal Plug_Connected. Ce signal Flag.Activation est égal à 1 lorsque la batterie n'est pas connectée à l'alimentation externe, le procédé étant alors activé, et égal à 0 lorsque la batterie est connectée à l'alimentation externe.

Le signal filtré SOC_Filtre(t) est alors déterminé (bloc 50 de la figure 5) comme étant égal à la valeur déterminée précédemment à l'étape g1) ou g2) lorsque la valeur du signal Flag_Activation est égale à 1 et égal à la valeur du signal initial SOC_Brut(t) à l'instant t si la valeur du signal Flag_Activation est égale à 0.

La figure 7 montre un exemple du signal initial SOC_Brut(t) en fonction du temps (courbe C3) et du signal filtré SOC_Filtre(t) en fonction du temps (courbe C1) correspondant.

Des recalages R1, R2 sont visibles sur l'évolution du signal initial SOC_Brut(t) aux temps t=145 et t=159 secondes. Ces recalages sont en revanche absents du signal filtré SOC_Filtre(t).

En roulage, le signal quantifiant l'état de charge de la batterie est intuitif si son évolution est, à tout moment, cohérente avec le flux de puissance entrant ou sortant de la batterie, c'est-à-dire si le signal quantifiant l'état de charge de la batterie varie à tout moment dans le même sens que le flux de puissance entrant ou sortant de la batterie. Par conséquent, le signal le plus intuitif est celui qu'on obtiendrait si on intégrait tout le temps la puissance fournie ou récupérée par la batterie.

Ce signal le plus intuitif est représenté sur la courbe C2 de la figure 7.

Le signal filtré SOC_Filtre(t) (courbe C1) suit les variations de la courbe C2 représentant le signal obtenu par intégration de la puissance fournie ou récupérée par la batterie, et présente à chaque instant t une variation dans le même sens que ce signal le plus intuitif.

Dans la partie basse de la figure 7, la courbe C4 montre l'évolution dans le temps du couple de la machine électrique. Par convention, ce couple est positif quand la machine fonctionne en moteur, il est négatif quand la machine fonctionne en générateur.

On peut également déduire de la comparaison entre la courbe C1 représentant le signal filtré SOC_Filtre et la courbe C4 montrant l'évolution dans le temps du couple de la machine électrique que l'évolution du signal filtré reste cohérente avec celle du couple de la machine électrique. En effet, ce signal filtré augmente lors des phases de fonctionnement générateur de la machine, ce qui correspond à un flux de puissance récupérée par la batterie et diminue lors des phases de fonctionnement moteur, ce qui correspond à un flux de puissance fournie par la batterie.

L'évolution du signal filtré SOC_Filtre en fonction du temps correspond ainsi toujours à l'évolution attendue par l'utilisateur qui se base sur sa perception de la puissance fournie ou récupérée par la batterie, donc sur sa perception du couple de la machine électrique.

Le signal filtré SOC_Filtre(t) obtenu grâce au procédé selon l'invention constitue ainsi un compromis entre le signal le plus précis qui est le signal initial SOC_Brut(t) et le signal le plus intuitif lié à la puissance fournie ou récupérée par la batterie.

Il présente ainsi une précision satisfaisante tout en restant compréhensible pour l'utilisateur du véhicule.

Le choix de la vitesse de convergence via le choix des paramètres K11, K12, K13, K21, K22, K23 de réglage, et en particulier des paramètres K11 (t) et K21 (t), permet d'ajuster ce compromis entre précision et intuitivité.

Une vitesse de convergence élevée, donc un paramètre K11 et/ou K21 de valeur élevée implique que le signal SOC_Filtre converge rapidement vers le signal SOC_Brut. On privilégie ainsi la précision du signal SOC_Filtre à son intuitivité.

Une vitesse de convergence faible implique que l'allure du signal SOC_Filtre est proche de celle de la courbe représentant l'intégrale de la puissance électrique mais la convergence vers le signal SOC_Brut est lente. On privilégie ainsi l'intuitivité du signal SOC_Filtre à sa précision.

La présente invention n'est nullement limitée aux modes de réalisation décrits et représentés mais l'homme du métier saura y apporter toute variante conforme à l'objet revendiqué.

Il est possible d'envisager par exemple de calculer d'abord la première valeur V1 possible, de réaliser l'étape de comparaison f1) et si la première valeur V1 possible est supérieure à la valeur du signal inital SOC_Brut(t) l'instant t, de déterminer la valeur du signal filtré SOC_Filtre (t) recherché comme étant égale à la première valeur possible V1. Selon cette variante, la deuxième valeur V2 n'est pas calculée.

On peut également déterminer la deuxième valeur V2 en premier. Dans l'hypothèse où l'on calcule systématiquement les première et deuxième valeur V1, V2, comme dans le mode de réalisation présenté ci-dessus, l'ordre des étapes de comparaison f1) et f2) peut également être inversé.

On peut enfin calculer une seule valeur possible pour le signal filtré SOC_Filtre(t) à l'instant t, en faisant l'hypothèse que cette valeur sera inférieure ou supérieure à la valeur du signal initial SOC_Brut(t) à l'instant t. Cette hypothèse peut par exemple être basée sur l'écart entre la valeur SOC_Filtre(t-1) du signal filtré à l'instant précédent t-1, la valeur du signal initial SOC_Brut(t) à l'instant t, et le coefficient de variation P1(t-1) ou P2(t-1) déterminé pour le signal filtré SOC_Filtre à l'instant t-1.

**Revendications**

1. Procédé de traitement d'un signal initial (SOC_Brut(t)) quantifiant l'état de charge d'une batterie électrique d'un véhicule automobile en fonction du temps pour obtenir un signal filtré (SOC_Filtre(t)) en fonction du temps, selon lequel on réalise, à chaque instant t, les étapes suivantes :

   a) on détermine une différence (DIFF(t)) entre la valeur (SOC_Brut(t)) dudit signal initial à l'instant t et la valeur du signal filtré (SOC_Filtre(t-1)) déterminée à l'instant précédent t-1,
   b) on détermine une variation théorique (Variat_TH(t)) de l'état de charge de la batterie à l'instant t en fonction de la puissance électrique fournie ou récupérée par la batterie à l'instant t,

c) on détermine la valeur du signal filtré (SOC_Filtre(t)) à l'instant t en fonction de la différence (DIFF(t)) déterminée à l'étape a) et de la variation théorique Variat_TH(t) déterminée à l'étape b), de telle sorte que le signal filtré (SOC Filtre(t)) converge vers le signal initial (SOC Brut(t)).

2. Procédé selon la revendication 1, selon lequel à l'étape c),

d) on détermine au moins un coefficient de variation (P1(t), P2(t)) du signal filtré (SOC_Filtre(t)) à l'instant t, en fonction de la différence (DIFF(t)) déterminée à l'étape a) et de la variation théorique (Variàt_TH(t)) déterminée à l'étape b),

e) on détermine une valeur du signal filtré (SOC_Filtre(t)) à l'instant t en fonction de ce coefficient de variation (P1(t), P2(t)) et de la durée (Dt) séparant l'instant t de l'instant précédent t-1.

3. Procédé selon la revendication 2, selon lequel à l'étape e), on ajoute à la valeur du signal filtré (SOC_Filtre(t-1)) à l'instant précédent t-1 le produit de ce coefficient de variation (P1(t), P2(t)) et de la durée (Dt) séparant l'instant t de l'instant précédent t-1.

4. Procédé selon l'une des revendications 2 et 3, selon lequel:

d1) on détermine, à l'étape d), un premier coefficient de variation (P1 (t)) du signal filtré (SOC_Filtre(t)) à l'instant t, correspondant au cas où la valeur du signal filtré (SOC_Filtre(t)) à l'instant t déterminée par ledit procédé est supérieure à la valeur du signal initial (SOC_Brut(t)) à l'instant t,

e1) on détermine, à l'étape e), une première valeur (V1) possible du signal filtré (SOC_Filtre(t)) à l'instant t, en fonction du premier coefficient de variation (P1 (t)) et de la durée (Dt) séparant l'instant t de l'instant précédent t-1,

f1) on compare la première valeur (V1) déterminée à l'étape e1) avec la valeur du signal initial (SOC_Brut(t)) à l'instant t,

g1) on détermine la valeur du signal filtré (SOC_Filtre(t)) en fonction du résultat de la comparaison réalisée à l'étape f1).

5. Procédé selon la revendication 4, selon lequel, la comparaison réalisée à l'étape f1) ayant montré que la première valeur (V1) possible est supérieure à la valeur du signal initial (SOC_Brut(t)), la valeur du signal filtré (SOC_Filtre(t)) à l'instant t est déterminée comme étant égale à la première valeur (V1) possible.

6. Procédé selon l'une des revendications 2 à 5, selon lequel :

d2) on détermine, à l'étape d), un deuxième coefficient de variation (P2(t)) du signal filtré (SOC_Filtre(t)) à l'instant t correspondant au cas où la valeur du signal filtré (SOC_Filtre(t)) à l'instant t déterminée par ledit procédé est inférieure à la valeur du signal initial (SOC_Brut(t)) à l'instant t,

e2) on détermine, à l'étape e), une deuxième valeur (V2) possible du signal filtré (SOC_Filtre(t)) à l'instant t, en fonction du deuxième coefficient de variation (P2(t)) et de la durée (Dt) séparant l'instant t de l'instant précédent t-1,

f2) on compare la deuxième valeur (V2) possible déterminée à l'étape e2) avec la valeur du signal initial (SOC_Brut(t)) à l'instant t,

g2) on détermine la valeur du signal filtré (SOC_Filtre(t)) en fonction du résultat de la comparaison réalisée à l'étape f2).

7. Procédé selon la revendication 6, selon lequel, la comparaison réalisée à l'étape f2) ayant montré que la deuxième valeur (V2) possible est inférieure à la valeur du signal initial (SOC_Brut(t)), la valeur du signal filtré (SOC_Filtre(t)) à l'instant t est déterminée comme étant égale à la deuxième valeur (V2) possible.

8. Procédé selon les revendications 4 et 6, selon lequel, la comparaison réalisée à l'étape f1) ayant montré que la première valeur (V1) possible est inférieure ou égale à la valeur du signal initial (SOC_Brut(t)), et la comparaison réalisée à l'étape f2) ayant montré que la deuxième valeur (V2) possible est supérieure ou égale à la valeur du signal initial (SOC_Brut(t)), la valeur du signal filtré (SOC_Filtre(t)) à l'instant t est déterminée comme étant égale à la valeur du signal initial (SOC_Brut(t)) à l'instant t.

9. Procédé selon l'une des revendications 4 à 8, selon lequel le premier coefficient de variation (P1 (t)) du signal filtré (SOC_Filtre(t)) à l'instant t est déterminé en fonction d'une première somme (S1 (t)) :

- de la variation théorique (Variat_TH(t)) de l'état de charge de la batterie à l'instant t,
- du produit d'un premier facteur (K11) et de la différence (DIFF(t)) déterminée à l'étape a), et
- d'un deuxième facteur (K12).

10. Procédé selon la revendication 9, selon lequel le premier facteur (K11) est une constante ou une fonction du temps et le deuxième facteur (K12) est une constante.

11. Procédé selon l'une des revendications 9 et 10, selon lequel le premier coefficient de variation (P1(t)) est égal au minimum de ladite première somme (S1(t)) et d'une valeur maximale prédéterminée (K13).

12. Procédé selon l'une des revendications 6 à 8, selon lequel le deuxième coefficient de variation (P2(t)) du signal filtré (SOC_Filtre(t)) à l'instant t est déterminé en fonction d'une deuxième somme (S2(t)) :

- de la variation théorique (Variat_TH(t)) de l'état de charge de la batterie à l'instant t,
- du produit d'un troisième facteur (K21) et de la différence (DIFF(t)) déterminée à l'étape a), et
- d'un quatrième facteur (K22).

13. Procédé selon la revendication 12, selon lequel le troisième facteur (K21), est une constante ou une fonction du temps et le quatrième facteur (K22) est une constante.

14. Procédé selon l'une des revendications 12 et 13, selon lequel le deuxième coefficient de variation (P2(t)) est égal au maximum de ladite deuxième somme (S2(t)) et d'une valeur minimale prédéterminée (K23).

15. Procédé selon l'une des revendications précédentes, selon lequel la variation théorique (Variat_TH(t)) de l'état de charge de la batterie à l'instant t est égale à la puissance électrique fournie ou récupérée par la batterie à l'instant t multipliée par un facteur de conversion Kconv.

16. Procédé selon l'une des revendications précédentes, selon lequel, au premier instant t0 de mise en oeuvre du procédé, la valeur du signal filtré (SOC_Filtre(t0)) est égale à la valeur du signal initial (SOC_Brut(t0)) à ce premier instant t0.

17. Véhicule automobile comportant une batterie électrique et une unité de commande informatique et électronique programmée pour traiter un signal initial (SOC_Brut(t)) quantifiant l'état de charge d'une batterie électrique selon le procédé de l'une quelconque des revendications précédentes.

**Patentansprüche**

1. Verfahren zur Verarbeitung eines Ausgangssignals (SOC_Brut(t)) zur zeitabhängigen Quantifizierung des Ladungszustands einer elektrischen Batterie eines Kraftfahrzeugs, um zeitabhängig ein gefiltertes Signal (SOC_Filtre(t)) zu erhalten, wonach zu jedem Zeitpunkt t die folgenden Schritte durchgeführt werden:

a) es wird eine Differenz (DIFF(t)) zwischen dem Wert (SOC_Brut(t)) des Ausgangssignals zu dem Zeitpunkt t und dem Wert des gefilterten Signals (SOC_Filtre(t-1)), der zum vorhergehenden Zeitpunkt t-1 bestimmt wird, bestimmt,
b) es wird eine theoretische Änderung (Variat_TH(t)) des Ladungszustands der Batterie zu dem Zeitpunkt t in Abhängigkeit von der elektrischen Leistung, die von der Batterie zu dem Zeitpunkt t zugeführt oder zurückgewonnen wird, bestimmt,
c) es wird der Wert des gefilterten Signals (SOC_Filtre(t)) zu dem Zeitpunkt t in Abhängigkeit von der Differenz (DIFF(t)), die in dem Schritt a) bestimmt wird, und von der theoretischen Änderung (Variat_TH(t)), die in dem Schritt b) bestimmt wird, derart bestimmt, dass das gefilterte Signal (SOC_Filtre(t)) zu dem Ausgangssignal (SOC_Brut(t)) hin konvergiert.

2. Verfahren nach Anspruch 1, wobei in dem Schritt c)

d) mindestens ein Variationskoeffizient (P1(t), P2(t)) des gefilterten Signals (SOC_Filtre(t)) zu dem Zeitpunkt t in Abhängigkeit von der Differenz (DIFF(t)), die in dem Schritt a) bestimmt wird, und von der theoretischen Änderung (Variat_TH(t)), die in dem Schritt b) bestimmt wird, bestimmt wird,

e) ein Wert des gefilterten Signals (SOC_Filtre(t)) zu dem Zeitpunkt t in Abhängigkeit von diesem Variationskoeffizienten (P1(t), P2(t)) und der Dauer (Dt) bestimmt wird, die den Zeitpunkt t von dem vorhergehenden Zeitpunkt t-1 trennt.

3. Verfahren nach Anspruch 2, wobei in dem Schritt e) zu dem Wert des gefilterten Signals (SOC_Filtre(t-1)) zu dem vorhergehenden Zeitpunkt t-1 das Produkt des Variationskoeffizienten (P1(t), P2(t)) und der Dauer (Dt), die den Zeitpunkt t von dem vorhergehenden Zeitpunkt t-1 trennt, hinzugefügt wird.

4. Verfahren nach einem der Ansprüche 2 und 3, wobei:

d1) in dem Schritt d) ein erster Variationskoeffizient (P1(t)) des gefilterten Signals (SOC_Filtre(t)) zu dem Zeitpunkt t bestimmt wird, der dem Fall entspricht, in dem der Wert des gefilterten Signals (SOC_Filtre(t)) zu dem Zeitpunkt t, der von dem Verfahren bestimmt wird, höher als der Wert des Ausgangssignals (SOC_Brut(t)) zu dem Zeitpunkt t ist,
e1) in dem Schritt e) ein erster möglicher Wert (V1) des gefilterten Signals (SOC_Filtre(t)) zu dem Zeitpunkt t in Abhängigkeit von dem ersten Variationskoeffizienten (P1(t)) und der Dauer (Dt) bestimmt wird, die den Zeitpunkt t von dem vorhergehenden Zeitpunkt t-1 trennt,
f1) der erste Wert (V1), der in dem Schritt e1) bestimmt wird, mit dem Wert des Ausgangssignals (SOC_Brut(t)) zu dem Zeitpunkt t verglichen wird,
g1) der Wert des gefilterten Signals (SOC_Filtre(t)) in Abhängigkeit von dem Ergebnis des Vergleichs bestimmt wird, der in dem Schritt f1) durchgeführt wird.

5. Verfahren nach Anspruch 4, wonach, nachdem der Vergleich, der in dem Schritt f1) durchgeführt wird, gezeigt hat, dass der erste mögliche Wert (V1) höher als der Wert des Ausgangssignals (SOC_Brut(t)) ist, der Wert des gefilterten Signals (SOC_Filtre(t)) zu dem Zeitpunkt t als gleich dem ersten möglichen Wert (V1) bestimmt wird.

6. Verfahren nach einem der Ansprüche 2 bis 5, wobei:

d2) in dem Schritt d) ein zweiter Variationskoeffizient (P2(t)) des gefilterten Signals (SOC_Filtre(t)) zu dem Zeitpunkt t bestimmt wird, der dem Fall entspricht, in dem der Wert des gefilterten Signals (SOC_Filtre(t)) zu dem Zeitpunkt t, der von dem Verfahren bestimmt wird, niedriger als der Wert des Ausgangssignals (SOC_Brut(t)) zu dem Zeitpunkt t ist,
e2) in dem Schritt e) ein zweiter möglicher Wert (V2) des gefilterten Signals (SOC_Filtre(t)) zu dem Zeitpunkt t in Abhängigkeit von dem zweiten Variationskoeffizienten (P2(t)) und der Dauer (Dt) bestimmt wird, die den Zeitpunkt t von dem vorhergehenden Zeitpunkt t-1 trennt,
f2) der zweite mögliche Wert (V2), der in dem Schritt e2) bestimmt wird, mit dem Wert des Ausgangssignals (SOC_Brut(t)) zu dem Zeitpunkt t verglichen wird,
g2) der Wert des gefilterten Signals (SOC_Filtre(t)) in Abhängigkeit von dem Ergebnis des Vergleichs bestimmt wird, der in dem Schritt f2) durchgeführt wird.

7. Verfahren nach Anspruch 6, wonach, nachdem der Vergleich, der in dem Schritt f2) durchgeführt wird, gezeigt hat, dass der zweite mögliche Wert (V2) niedriger als der Wert des Ausgangssignals (SOC_Brut(t)) ist, der Wert des gefilterten Signals (SOC_Filtre(t)) zu dem Zeitpunkt t als gleich dem zweiten möglichen Wert (V2) bestimmt wird.

8. Verfahren nach Anspruch 4 und 6, wonach, nachdem der Vergleich, der in dem Schritt f1) durchgeführt wird, gezeigt hat, dass der erste mögliche Wert (V1) niedriger als oder gleich dem Wert des Ausgangssignals (SOC_Brut(t)) ist, und der Vergleich, der in dem Schritt f2) durchgeführt wird, gezeigt hat, dass der zweite mögliche Wert (V2) höher als oder gleich dem Wert des Ausgangssignals (SOC_Brut(t)) ist, der Wert des gefilterten Signals (SOC_Filtre(t)) zu dem Zeitpunkt t als gleich dem Wert des Ausgangssignals (SOC_Brut(t)) zu dem Zeitpunkt t bestimmt wird.

9. Verfahren nach einem der Ansprüche 4 bis 8, wobei der erste Variationskoeffizient (P1(t)) des gefilterten Signals (SOC_Filtre(t)) zu dem Zeitpunkt t in Abhängigkeit von einer ersten Summe (S1(t)):

- der theoretischen Änderung (Variat_TH(t)) des Ladungszustands der Batterie zu dem Zeitpunkt t,
- des Produktes eines ersten Faktors (K11) und der Differenz (DIFF(t)), die in dem Schritt a) bestimmt wird, und
- von einem zweiten Faktor (K12) bestimmt wird.

10. Verfahren nach Anspruch 9, wobei der erste Faktor (K11) eine Konstante oder eine Funktion der Zeit und der zweite Faktor (K12) eine Konstante ist.

11. Verfahren nach einem der Ansprüche 9 und 10, wobei der erste Variationskoeffizient (P1(t)) gleich dem Mindestwert der ersten Summe (S1(t)) und eines vorbestimmten maximalen Werts (K13) ist.

12. Verfahren nach einem der Ansprüche 6 bis 8, wobei der zweite Variationskoeffizient (P2(t)) des gefilterten Signals (SOC_Filtre(t)) zu dem Zeitpunkt t in Abhängigkeit von einer zweiten Summe (S2(t)):

    - der theoretischen Änderung (Variat_TH(t)) des Ladungszustands der Batterie zu dem Zeitpunkt t,
    - des Produktes eines dritten Faktors (K21) und der Differenz (DIFF(t)), die in dem Schritt a) bestimmt wird, und
    - von einem vierten Faktor (K22) bestimmt wird.

13. Verfahren nach Anspruch 12, wobei der dritte Faktor (K21) eine Konstante oder eine Funktion der Zeit und der vierte Faktor (K22) eine Konstante ist.

14. Verfahren nach einem der Ansprüche 12 und 13, wobei der zweite Variationskoeffizient (P2(t)) gleich dem Höchstwert der zweiten Summe (S2(t)) und eines vorbestimmten minimalen Werts (K23) ist.

15. Verfahren nach einem der vorhergehenden Ansprüche, wobei die theoretische Änderung (Variat_TH(t)) des Ladungszustands der Batterie zu dem Zeitpunkt t gleich der elektrischen Leistung, die von der Batterie zu dem Zeitpunkt t zugeführt oder zurückgewonnen wird, multipliziert mit einem Konversionsfaktor Kconv ist.

16. Verfahren nach einem der vorhergehenden Ansprüche, wobei zu dem ersten Zeitpunkt t0 der Umsetzung des Verfahrens der Wert des gefilterten Signals (SOC_Filtre(t0)) gleich dem Wert des Ausgangssignals (SOC_Brut(t0)) zu diesem ersten Zeitpunkt t0 ist.

17. Kraftfahrzeug, umfassend eine elektrische Batterie und eine elektronische Computersteuereinheit, die programmiert ist, um ein Ausgangssignal (SOC_Brut (t)) zu verarbeiten, das den Ladungszustand einer elektrischen Batterie nach dem Verfahren nach einem der vorhergehenden Ansprüche quantifiziert.

**Claims**

1. Method for processing an initial signal (SOC_Raw(t)) quantifying the state of charge of an electric battery of a motor vehicle as a function of time to obtain a filtered signal (SOC_Filter(t)) as a function of time, whereby the following steps are carried out at each instant t:

    a) a difference (DIFF(t)) is determined between the value (SOC_Raw(t)) of said initial signal at the instant t and the value of the filtered signal (SOC_Filter(t-1)) determined at the preceding instant t-1,
    b) a theoretical variation (Variat_TH(t)) of the state of charge of the battery at the instant t is determined as a function of the electrical power supplied or recovered by the battery at the instant t,
    c) the value of the filtered signal (SOC_Filter(t)) at the instant t is determined as a function of the difference (DIFF(t)) determined in the step a) and of the theoretical variation Variat_TH(t) determined in the step b), such that the filtered signal (SOC Filter(t)) converges toward the initial signal (SOC Raw(t)).

2. Method according to Claim 1, whereby, in the step C),

    d) at least one coefficient of variation (P1(t), P2(t)) of the filtered signal ((SOC_Filter(t)) at the instant t is determined, as a function of the difference (DIFF(t)) determined in the step a) and of the theoretical variation (Variat_TH(t)) determined in the step b),
    e) a value of the filtered signal (SOC_Filter(t)) at the instant t is determined as a function of this coefficient of variation (P1(t), P2(t)) and of the duration (Dt) separating the instant t from the preceding instant t-1.

3. Method according to Claim 2, whereby, in the step e), the product of this coefficient of variation (P1(t), P2(t)) and of the duration (Dt) separating the instant t from the preceding instant t-1 is added to the value of the filtered signal (SOC_Filter(t-1)) at the preceding instant t-1.

4. Method according to either of Claims 2 and 3, whereby:

d1) in the step d), a first coefficient of variation (P1(t)) of the filtered signal (SOC_Filter(t)) at the instant t is determined, corresponding to the case where the value of the filtered signal (SOC_Filter(t)) at the instant t determined by said method is greater than the value of the initial signal (SOC_Raw(t)) at the instant t,

e1) in the step e), a first possible value (V1) of the filtered signal (SOC_Filter(t)) at the instant t is determined, as a function of the first coefficient of variation (P1(t)) and of the duration (Dt) separating the instant t from the preceding instant t-1,

f1) the first value (V1) determined in the step e1) is compared with the value of the initial signal (SOC_Raw(t)) at the instant t,

g1) the value of the filtered signal (SOC_Filter(t)) is determined as a function of the result of the comparison performed in the step f1) .

5. Method according to Claim 4, whereby, the comparison performed in the step f1) having shown that the first possible value (V1) is greater than the value of the initial signal (SOC_Raw(t)), the value of the filtered signal (SOC_Filter(t)) at the instant t is determined as being equal to the first possible value (V1).

6. Method according to one of Claims 2 to 5, whereby:

d2) in the step d), a second coefficient of variation (P2(t)) of the filtered signal (SOC_Filter(t)) at the instant t is determined, corresponding to the case where the value of the filtered signal (SOC_Filter(t)) at the instant t determined by said method is less than the value of the initial signal (SOC_Raw(t)) at the instant t,

e2) in the step e), a second possible value (V2) of the filtered signal (SOC_Filter(t)) at the instant t is determined, as a function of the second coefficient of variation (P2(t)) and of the duration (Dt) separating the instant t from the preceding instant t-1,

f2) the second possible value (V2) determined in the step e2) is compared with the value of the initial signal (SOC_Raw(t)) at the instant t,

g2) the value of the filtered signal (SOC_Filter(t)) is determined as a function of the result of the comparison performed in the step f2).

7. Method according to Claim 6, whereby, the comparison performed in the step f2) having shown that the second possible value (V2) is less than the value of the initial signal (SOC_Raw(t)), the value of the filtered signal (SOC_Filter(t)) at the instant t is determined as being equal to the second possible value (V2).

8. Method according to Claims 4 and 6, whereby, the comparison performed in the step f1) having shown that the first possible value (V1) is less than or equal to the value of the initial signal (SOC_Raw(t)), and the comparison performed in the step f2) having shown that the second possible value (V2) is greater than or equal to the value of the initial signal (SOC_Raw(t)), the value of the filtered signal (SOC_Filter(t)) at the instant t is determined as being equal to the value of the initial signal (SOC_Raw(t)) at the instant t.

9. Method according to one of Claims 4 to 8, whereby the first coefficient of variation (P1(t)) of the filtered signal (SOC_Filter(t)) at the instant t is determined as a function of a first sum (S1(t)):

- of the theoretical variation (Variat_TH(t)) of the state of charge of the battery at the instant t,
- of the product of a first factor (K11) and of the difference (DIFF(t)) determined in the step a), and
- of a second factor (K12).

10. Method according to Claim 9, whereby the first factor (K11) is a constant or a function of time and the second factor (K12) is a constant.

11. Method according to either of Claims 9 and 10, whereby the first coefficient of variation (P1(t)) is equal to the minimum of said first sum (S1(t)) and of a predetermined maximum value (K13).

12. Method according to one of Claims 6 to 8, whereby the second coefficient of variation (P2(t)) of the filtered signal (SOC_Filter(t)) at the instant t is determined as a function of a second sum (S2(t)):

- of the theoretical variation (Variat_TH(t)) of the state of charge of the battery at the instant t,
- of the product of a third factor (K21) and of the difference (DIFF(t)) determined in the step a), and
- of a fourth factor (K22).

13. Method according to Claim 12, whereby the third factor (K21) is a constant or a function of time and the fourth factor (K22) is a constant.

14. Method according to either of Claims 12 and 13, whereby the second coefficient of variation (P2(t)) is equal to the maximum of said second sum (S2(t)) and of a predetermined minimum value (K23).

15. Method according to one of the preceding claims, whereby the theoretical variation (Variat_TH(t)) of the state of charge of the battery at the instant t is equal to the electrical power supplied or recovered by the battery at the instant t multiplied by a conversion factor Kconv.

16. Method according to one of the preceding claims, whereby, at the first instant t0 of implementation of the method, the value of the filtered signal (SOC_Filter(t0)) is equal to the value of the initial signal (SOC_Raw(t0)) at this first instant t0.

17. Motor vehicle comprising an electric battery and a computerized and electronic control unit programmed to process an initial signal (SOC_Raw(t)) quantifying the state of charge of an electric battery according to the method of any one of the preceding claims.

Fig.1

EP 2 705 381 B1

Fig.2

Fig.3

Fig.4

Fig.5

SOC_Filtre(t-1)

P1(t)

x Dt

41B

41A

V1

45

43

42A

SOC_Filtre(t-1)

P2(t)

x Dt

42B

V2

46

SOC_Brut(t)

44

50

4

Flag_Activation(t)

SOC_Filtre(t)

EP 2 705 381 B1

Fig.6

Fig.7

## RÉFÉRENCES CITÉES DANS LA DESCRIPTION

**Documents brevets cités dans la description**

- EP 1707974 A
- EP 1983349 A
- US 2004076872 A
- US 20030214303 A
- EP 1801604 A
- JP 2000150003 B